## Europäisches Patentamt

## European Patent Office

## Office européen des brevets

(19)

(11) Veröffentlichungsnummer: **0 070 032**
**B1**

(12) **EUROPÄISCHE PATENTSCHRIFT**

(45) Veröffentlichungstag der Patentschrift:
**13.02.85**

(21) Anmeldenummer: **82106268.4**

(22) Anmeldetag: **13.07.82**

(51) Int. Cl.⁴: **H 03 K 17/60, H 03 K 17/78**

(54) **Ansteuerschaltung für wenigstens eine lichtemittierende Diode.**

(30) Priorität: **15.07.81 DE 3128013**

(43) Veröffentlichungstag der Anmeldung:
**19.01.83 Patentblatt 83/3**

(45) Bekanntmachung des Hinweises auf die Patenterteilung:
**13.02.85 Patentblatt 85/7**

(84) Benannte Vertragsstaaten:
**AT BE CH DE FR GB IT LI NL SE**

(56) Entgegenhaltungen:
**DE - B - 1 285 004**

(73) Patentinhaber: **Siemens Aktiengesellschaft, Berlin und München Wittelsbacherplatz 2, D-8000 München 2 (DE)**

(72) Erfinder: **Goerne, Jan, Dipl.-Ing.,
Heinrich-Vogl-Strasse 8, D-8000 München 71 (DE)**
Erfinder: **Traulsen, Wilfried, Dipl.-Ing.,
Karl-Marx-Ring 96, D-8000 München 83 (DE)**

# Beschreibung

Die Erfindung bezieht sich auf eine Ansteuerschaltung für wenigstens eine lichtemittierende Diode, bei der die lichtemittierende Diode in einen Speisestromkreis eingefügt ist und bei der neben dem Speisestromkreis eine Transistorgegentaktschaltung und eine Verbindungsleitung zwischen dem Verbindungspunkt der Transistoren der Gegentaktschaltung und dem Speisestromkreis vorgesehen ist.

Eine solche Ansteuerschaltung ist aus der DE-AS 2 850 044 bekannt. In der Verbindungsleitung ist bei der bekannten Schaltungsanordnung ein von einem Kondensator überbrückter ohmscher Widerstand vorgesehen. Je nachdem, welcher der beiden Transistoren der Gegentaktschaltung gesperrt bzw. geöffnet ist, wird die lichtemittierende Diode entweder »kurzgeschlossen« oder erhält zusätzlichen Speisestrom von der Gegentaktschaltung. Damit die lichtemittierende Diode im kurzgeschlossenen Zustand sicher gesperrt ist, muß die in diesem Fall an der lichtemittierenden Diode wirksame Potentialdifferenz kleiner sein als deren Schwellspannung. Hierzu kann es erforderlich sein, die Speisespannungen für die Gegentaktschaltung und für den Speisestromkreis der lichtemittierenden Diode unterschiedlich groß zu machen. Dies ist jedoch häufig nicht erwünscht.

Aufgabe vorliegender Erfindung ist es daher, eine Ansteuerschaltung der eingangs genannten Art so auszubilden, daß keine besondere Sorgfalt für die Bemessung der in der Verbindungsleitung vorgesehenen Bauteile aufgewendet werden muß, und daß insbesondere keine unterschiedlich großen Speisespannungen für den Speisestromkreis der lichtemittierenden Diode und für die Transistorgegentaktschaltung benötigt werden.

Erfindungsgemäß ergibt sich die Lösung dieser Aufgabe dadurch, daß die Verbindungsleitung lediglich eine Diode unter Bildung eines über einen der beiden Transistoren der Gegentaktschaltung verlaufenden, zum Speisestrompfad der lichtemittierenden Diode parallelgerichteten Strompfades enthält, und daß in dem über die lichtemittierende Diode verlaufenden Speisestrompfad wenigstens eine zusätzliche, zur lichtemittierenden Diode in Serie geschaltete Diode vorgesehen ist.

Auf diese Weise ist im »Kurzschlußfall« der Serienschaltung aus lichtemittierender Diode und zusätzlicher Diode die Serienschaltung aus der Verbindungsleitungs-Diode und dem einen Gegentaktschaltungstransistor parallel geschaltet. Der Spannungsabfall an der aus der letztgenannten Serienschaltung (Diode und Transistor) bestehenden »Kurzschlußstrecke« beträgt dabei etwa 1,2 bis 1,4 Volt. Zum Durchsteuern einer lichtemittierenden Diode sind etwa 1,3 Volt erforderlich und da die zusätzliche Diode etwa 0,7 Volt benötigt, um durchgesteuert zu werden, müssen an der Serienschaltung aus zusätzlicher Diode und lichtemittierender Diode ungefähr 2 Volt liegen, um die lichtemittierende Diode durchzusteuern. Die Spannung von ca. 1,3 Volt an der »Kurzschlußstrecke« hält daher die lichtemittierende Diode sicher im gesperrten Zustand.

In weiterer Ausgestaltung der Erfindung ist die zusätzliche Diode auf der Seite des Verbindungspunktes Verbindungsleitungs-Diode-Speisestromkreis der lichtemittierenden Diode vorgesehen und zwischen dem Verbindungspunkt der Gegentakt-Transistoren und dem Verbindungspunkt zwischen der lichtemittierenden Diode und der zusätzlichen Diode ist ein Kondensator eingefügt.

Vorteilhaft wird auf diese Weise unter Umgehung der Verbindungsleitungs-Diode und der zusätzlichen Diode dem Speisestrom der lichtemittierenden Diode beim Umschalten der Gegentaktschaltung ein Stromimpuls überlagert. Durch den auf diese Weise gebildeten kurzzeitigen Überstrom wird die Zeitspanne zwischen dem Umschalten der Gegentaktschaltung und dem Zeitpunkt des Beginns maximaler Lichtemission durch die lichtemittierende Diode wesentlich verkürzt.

Ein Ausführungsbeispiel der Erfindung wird nachfolgend anhand eines in einer Figur dargestellten Schaltbildes noch näher erläutert.

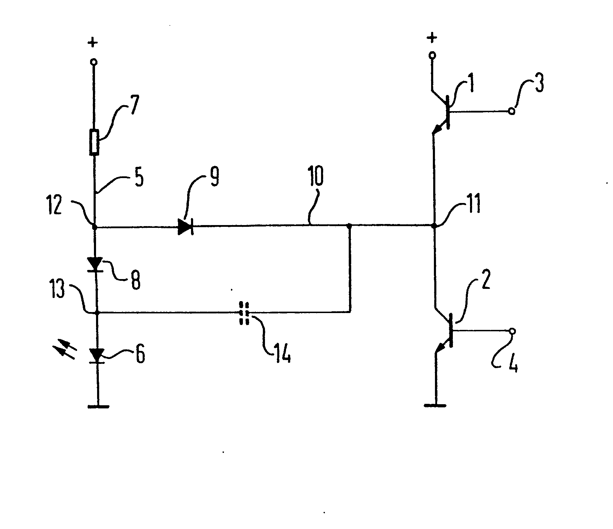

Aus der Figur ist zu ersehen, daß eine aus zwei Transistoren 1, 2 gleichen Leitfähigkeitstyps gebildete Gegentaktschaltung vorgesehen ist. Die Transistoren werden dabei über Eingänge 3, 4, die mit ihren Basiselektroden verbunden sind, von zueinander gegenphasigen Signalen so beeinflußt, daß entweder der Transistor 1 oder der Transistor 2 gesperrt ist, und daß der jeweils andere Transistor mit seiner Kollektor-Emitter-Strecke niederohmig gesteuert ist.

Aus der Figur ist weiter zu ersehen, daß in einen Speisestromkreis 5, der z. B. zwischen dem Plus-Pol einer Spannungsquelle und dem mit Masse verbundenen Minus-Pol der Spannungsquelle verläuft, eine lichtemittierende Diode 6 eingefügt ist. Zwischen der lichtemittierenden Diode 6 und einem Widerstand 7 im Speisestromkreis 5, der so bemessen ist, daß der maximale Speisestrom der lichtemittierenden Diode nicht überschritten wird, ist eine zusätzliche Diode 8 vorgesehen.

Eine Verbindungsleitungs-Diode 9 verbindet außerdem den Verbindungspunkt 11 der Transistoren 1, 2 der Gegentaktschaltung mit dem Verbindungspunkt 2 zwischen dem Widerstand 7 und der zusätzlichen Diode 8.

Die in der Verbindungsleitung 10 vorgesehene Diode 9 und die Kollektor-Emitter-Strecke des Transistors 2 der Gegentaktschaltung bilden auf diese Weise eine »Kurzschlußstrecke« für die lichtemittierende Diode 6 und die zusätzliche Diode 8, wenn der Transistor 1 gesperrt ist und der Transistor 2 sich mit seiner Kollektor-Emitter-Strecke im niederohmigen Zustand befindet. Der Spannungsabfall an der Serienschaltung aus Diode 9 und Transistor 2 ist dann zu gering, um die Diode 8 und die lichtemittierende Diode 6 durchzusteuern. Die lichtemittierende Diode 6 ist daher stromlos und kann kein Licht emittieren.

Wird der Transistor 2 gesperrt und der Transistor 1 mit seiner Kollektor-Emitter-Strecke in den niederohmigen Zustand versetzt, dann sperrt die Diode 9 und an der Serienschaltung von Diode 8 und lichtemittierender Diode 6 liegt die Speisespannung des Speisestromkreises. Die lichtemittierende Diode 6 wird deshalb nun durchgesteuert und von dem durch den Widerstand 7 begrenzten Speisestrom durchflossen. In diesem Zustand emittiert die lichtemittierende Diode 6 Licht.

Zur Verbesserung insbesondere des Einschaltverhaltens der Diode 6 ist zwischen den Verbindungspunkt 11 der beiden Transistoren 1, 2 der Gegentaktschaltung und den Verbindungspunkt 13 zwischen der zusätzlichen Diode 8 und der lichtemittierenden Diode 6 ein Kondensator 14 eingefügt. Über diesen Kondensator 14 verläuft kurzzeitig ein zusätzlicher Speisestromkreis für die lichtemittierende Diode 6 vom Plus-Pol der Speisespannungsquelle, die mit dem Kollektor des Transistors 1 verbunden ist, über die Kollektor-Emitter-Strecke dieses Transistors 1, wenn der Transistor 1 von seinem gesperrten Zustand in den durchgeschalteten Zustand seiner Kollektor-Emitter-Strecke übergeht. Dieser Kondensator-Einschaltstromimpuls überlagert sich dem Strom des Speisestromkreises 5. Der auf diese Weise gebildete kurzzeitige Überstrom für die Diode 6 verkürzt die Zeitspanne, die die Diode 6 benötigt, um den Zustand maximaler Lichtemission zu erreichen, ist aber zu kurz, um die Diode 6 zu überlasten.

Ist der Einschaltvorgang für die Diode 6 abgeschlossen, so bezieht die Diode 6 ihren Speisestrom nur noch über den Stromkreis 5, der so bemessen ist, daß die Diode 6 nicht überlastet wird.

Wird der Transistor 1 gesperrt, dann wird zugleich die Kollektor-Emitter-Strecke des Transistors 2 niederohmig gesteuert und die Serienschaltung aus Diode 9 und Transistor 2 der Serienschaltung aus Diode 8 und Diode 6 wieder parallel geschaltet. Die Serienschaltung aus Diode 8 und Diode 6 wird dadurch für den Speisestrom unterbrochen und die lichtemittierende Diode 6 daher stromlos.

Liste der Bezugszeichen

1, 2 Transistoren der Gegentaktschaltung
3, 4 Ansteuereingänge der Gegentaktschaltung
5 Speisestromkreis
6 lichtemittierende Diode
7 Widerstand im Speisestromkreis
8 zusätzliche Diode
9 Verbindungsleitungs-Diode
10 Verbindungsleitung
11 Verbindungspunkt der Gegentakttransistoren
12 Verbindungspunkt Widerstand—zusätzliche Diode
13 Verbindungspunkt zusätzliche Diode—lichtemittierende Diode
14 Kondensator

## Patentansprüche

1. Ansteuerschaltung für wenigstens eine lichtemittierende Diode (6), bei der die lichtemittierende Diode in einen Speisestromkreis (5) eingefügt ist, und bei der neben dem Speisestromkreis eine Transistorgegentaktschaltung (1, 2) und eine Verbindungsleitung (10) zwischen dem Verbindungspunkt (11) der Transistoren der Gegentaktschaltung und dem Speisestromkreis vorgesehen ist, dadurch gekennzeichnet, daß die Verbindungsleitung (10) lediglich eine Diode (9) unter Bildung eines über einen der beiden Transistoren der Gegentaktschaltung verlaufenden, zum Speisestrompfad der lichtemittierenden Diode (6) parallelgerichteten Strompfades enthält, und daß in dem über die lichtemittierende Diode (6) verlaufenden Speisestrompfad wenigstens eine zusätzliche, zur lichtemittierenden Diode (6) in Serie geschaltete Diode (8) vorgesehen ist.

2. Ansteuerschaltung nach Anspruch 1, dadurch gekennzeichnet, daß die zusätzliche Diode (8) auf der Seite des Verbindungspunktes (12) Verbindungsleitungs-Diode-Speisestromkreis der lichtemittierenden Diode (6) vorgesehen ist, und daß zwischen dem Verbindungspunkt (11) der Gegentakt-Transistoren (1, 2) und dem Verbindungspunkt (13) zwischen der lichtemittierenden Diode (6) und der zusätzlichen Diode (8) ein Kondensator (14) eingefügt ist.

## Claims

1. A control circuit for at least one light-emitting diode (6) inserted into a feeder circuit (5), and wherein there are arranged in addition to the feeder circuit a transistor push-pull circuit (1, 2) and a connection line (10) between the junction point (11) of the transistors of the push-pull circuit and the feeder circuit, characterised in that the connection line (10) comprises one diode (9) forming a current path via one of the two transistors of the push-pull circuit and directed parallel to the feed current path of the light-emitting diode (6), and that in the feed current path via the light-emitting diode (6), there is arranged at least one additional diode (8) connected in series to the light-emitting diode (6).

2. A control circuit as claimed in claim 1, characterised in that the additional diode (8) is arranged at the junction point (12) on the feeder circuit side of the light-emitting diode (6), and that a capacitor (14) is inserted between the junction point (11) of the push-pull transistors (1, 2) and the junction point (13) between the light-emitting diode (6) and the additional diode (8).

## Revendications

1. Circuit d'attaque pour au moins une diode électroluminescente (6), dans lequel la diode électroluminescente est insérée dans un circuit d'alimentation en courant (5), et dans lequel il est prévu, en plus du circuit d'alimentation en courant, un circuit symétrique (1, 2) à transistors et un conducteur de liaison (10) entre le point de liaison (11) des transistors du circuit symétrique et le circuit d'alimentation en courant, caractérisé par le fait que le conducteur de liaison (10) comporte uniquement une diode (9) avec formation d'une piste conductrice passant par l'un des deux transistors du circuit symétrique et dirigée parallèlement à la piste d'alimentation en courant de la diode électroluminescente (6), et qu'il est prévu dans la piste d'alimentation en courant qui passe par la diode électroluminescente (6) au moins une diode supplémentaire (8) montée en série avec la diode électroluminescente (6).

2. Circuit d'attaque selon la revendication 1, caractérisé par le fait que la diode supplémentaire (8) est prévue du côté du point de liaison (12) conducteur de liaison diode-circuit d'alimentation en courant de la diode électroluminescente, et qu'entre le point de liaison (11) des transistors symétriques (1, 2) avec le point de liaison (13) entre la diode électroluminescente (6) et la diode supplémentaire (8), est inséré un condensateur (14).